# EUROPÄISCHE PATENTANMELDUNG

(11) **EP 2 388 808 A1**
(43) Veröffentlichungstag der Anmeldung: **23.11.2011**
(21) Anmeldenummer: 10163483.0
(22) Anmeldetag: 20.05.2010
(51) Int. Cl.: H01L 21/677

(54) **Berührungsloses Transportsystem**

(71) Anmelder: Westfälische Wilhelms-Universität Münster, 48149 Münster (DE); Kemenas, Jürgen, 47803 Krefeld (DE); Gohs, Norbert, 47803 Krefeld (DE)
(72) Erfinder: Bolz, Erwin, 52525 Heinsberg (DE); Weber, Frank, 41334 Nettetal (DE); Kemenas, Jürgen, 47803 Krefeld (DE)
(74) Vertreter: Dönges, Jörg

(57) **Zusammenfassung**

Die Erfindung betrifft ein berührungsloses Transportsystem für Gegenstände aus empfindlichen Materialien, insbesondere Wafer, mit einer insbesondere rechteckigen Grundplatte und einer Druckluftversorgung, wobei die Grundplatte Auslassöffnungen aufweist, durch welche die Druckluft austritt und den Gegenstand von der Grundplatte weg anhebt.

Um ein Transportsystem anzugeben, mit dem in einfacher Weise ein Transport von Gegenständen aus empfindlichen Materialien ohne die Gefahr mechanischer Beeinträchtigung des Gegenstandes erfolgen kann, soll die Auslassöffnungen als längliche nutförmige Kanäle ausgebildet sind, welche an der Oberfläche der Grundplatte verlaufen und oberseitig offen ausgebildet sind.

## Beschreibung

### Berührungsloses Transportsystem

Die Erfindung betrifft ein berührungsloses Transportsystem für Gegenstände aus empfindlichen Materialien, insbesondere Wafer, mit einer insbesondere rechteckigen Grundplatte und einer Druckluftversorgung, wobei die Grundplatte Auslassöffnungen aufweist, durch welche die Druckluft austritt und den Gegenstand von der Grundplatte weg anhebt.

Aus der Praxis sind derartige Transportsystem bekannt, bei denen das Anheben des Gegenstands zwar durch die austretende Druckluft bewirkt wird, die eigentliche Fortbewegung des Gegenstandes jedoch durch mechanische Kontakte erfolgt.

Nachteilig hierbei ist, dass dies zum einen aufwändig ist und zum anderen auch eine mechanische Beeinträchtigung des Gegenstandes verursachen kann.

Aufgabe der Erfindung ist es, die vorgenannten Nachteile zu vermeiden und ein Transportsystem anzugeben, mit dem in einfacher Weise ein Transport von Gegenständen aus empfindlichen Materialien ohne die Gefahr mechanischer Beeinträchtigung des Gegenstandes erfolgen kann.

Diese Aufgabe wird dadurch gelöst, dass die Auslassöffnungen als längliche nutförmige Kanäle ausgebildet sind, welche an der Oberfläche der Grundplatte verlaufen und oberseitig offen ausgebildet sind. Hierdurch wird durch die austretende Druckluft auch eine seitliche Kraftkomponente auf den angehobenen Gegenstand ausgeübt, wodurch dieser seitlich in Vorschubrichtung verlagert wird.

Vorteilhafterweise kann dieses Transportsystem für Wafer, die bei der Herstellung von Solarzellen verwendet werden, einsetzbar sein. Die Wafer können dabei insbesondere eine Dicke von ca. 20 µm bis 200 µm aufweisen und vorteilhafterweise rechteckig bzw. quadratisch mit Kantenlängen von 120 mm bis 200 mm ausgebildet sein.

Vorzugsweise können die Kanäle sich oberseitig erweiternd, insbesondere mit in etwa V-förmigem Querschnitt, ausgebildet sein.

Erfindungsgemäß können die in etwa V-förmigem Kanäle eine Tiefe von ca. 0,5 mm haben und der V-förmigem Querschnitt in etwa einen Winkel von. 50° bis 70°, insbesondere 60°, einschließen.

Vorteilhafterweise kann ein erster Teil der Kanäle in einem Winkel von ca. 30° bis 60°, insbesondere 45°, zur Vorschubrichtung ausgerichtet angeordnet sein. Weiterhin kann ein zweiter Teil der Kanäle in einem Winkel von ca. 120° bis 150°, insbesondere 135°, zur Vorschubrichtung ausgerichtet angeordnet sein. Dabei können sich die Kanäle kreuzen und/oder endseitig aneinander grenzen und somit insbesondere ineinander übergehen, also als Teilbereiche eines winklig, insbesondere rechtwinklig abknickenden Kanals ausgebildet sein.

Somit resultiert eine Vorwärts- bzw. Rückwärtsrichtung des Luftflusses aufgrund der winkligen Anordnung der Kanäle.

Auch kann zumindest ein Teil der Kanäle sich seitlich bis in den Randbereich der Grundplatte erstrecken und insbesondere maximal bis zum mittleren Bereich der Grundplatte reichen oder diesen freilassen.

Bevorzugt kann ein erster Teil der Kanäle seitlich jeweils mit einer ersten Duckluftzufuhr versehen ist, wobei insbesondere die Druckluftzufuhr als ein nutförmig in der Oberfläche der Grundplatte eingebrachter und oberseitig mit einer Abdeckung verschlossener Verteil-Kanal, in welchen der erste Teil der Kanäle mündet, ausgebildet sein kann.

Ferner kann ein zweiter Teil der Kanäle seitlich jeweils mit einer zweiten Duckluftzufuhr versehen sein, wobei insbesondere die Druckluftzufuhr als ein nutförmig in der Unterseite der Grundplatte eingebrachter und mit einer Abdeckung verschlossener Verteil-Kanal, in welchen über Durchlässe der zweite Teil der Kanäle mündet, ausgebildet sein kann.

Weiterhin kann die Grundplatte oberseitig mit einer mittigen Nut versehen sein, die insbesondere zur Aufnahme einer Sensorik, beispielsweise zur Kontrolle von Prozessparametern ausgebildet ist.

Vorteilhafterweise kann die Grundplatte aus Metall, insbesondere einer Aluminiumlegierung, oder Kunststoff, bestehen und die Kanäle können eingefräst oder eingegossen sein.

Erfindungsgemäß können die Kanäle in Vorschubrichtung gesehen in einem Abstand von 5 mm bis 30 mm vorgesehen sein.

Vorteilhafterweise kann zumindest ein Teil der Kanäle in der bevorzugten Vorschubrichtung eine sich verringernde Kanaltiefe und/oder ein sich verringerndes Kanalvolumen aufweisen, so dass eine weitgehend gleichmäßige Auftriebswirkung entlang der Länge der Kanäle resultiert. Die Tiefe der Kanäle kann sich dabei von ca. 0,7 mm am Beginn des Kanals bis auf ca. 0,1 mm am Ende des Kanals verringern.

Bei einem bevorzugten Ausführungsbeispiel der Erfindung kann zumindest ein Teil der Kanäle sich von der einen Seite der Grundplatte bis zur anderen Seite der Grundplatte erstrecken, so dass ein bei zu transportierenden Gegenständen aus flexiblen Materialien auftretender Sogeffekt in der ansonsten kanalfreien Mitte nicht auftritt.

Entsprechend der Form der zu transportierenden Gegenstände kann der seitliche Querschnittsverlauf der Grundplatte eben oder gekrümmt ausgebildet sein, es sind aber auch andere, z. B. einfach oder mehrfach abgewinkelte Formen möglich. Durch entsprechende Ausgestaltungen im Verlauf sind auch Kurven etc. möglich.

Vorzugsweise kann die Fördermenge der Duckluftzufuhr so gewählt sein, dass ein Wafer mit einer Fläche von 156 x 156 mm² und einem Gewicht von ca. 8 Gramm einen solchen Auftrieb erfährt, dass er ca. 20 - 30 µm angehoben wird. Die Fördermenge kann 14 1/min für eine Fläche des Transportsystems von ca. 160 x 1000 mm² betragen.

Im Folgenden wird ein in der Zeichnung dargestelltes Ausführungsbeispiel der Erfindung erläutert. In allen Figuren werden für gleiche bzw. gleichartige Bauteile übereinstimmende Bezugszeichen verwendet.

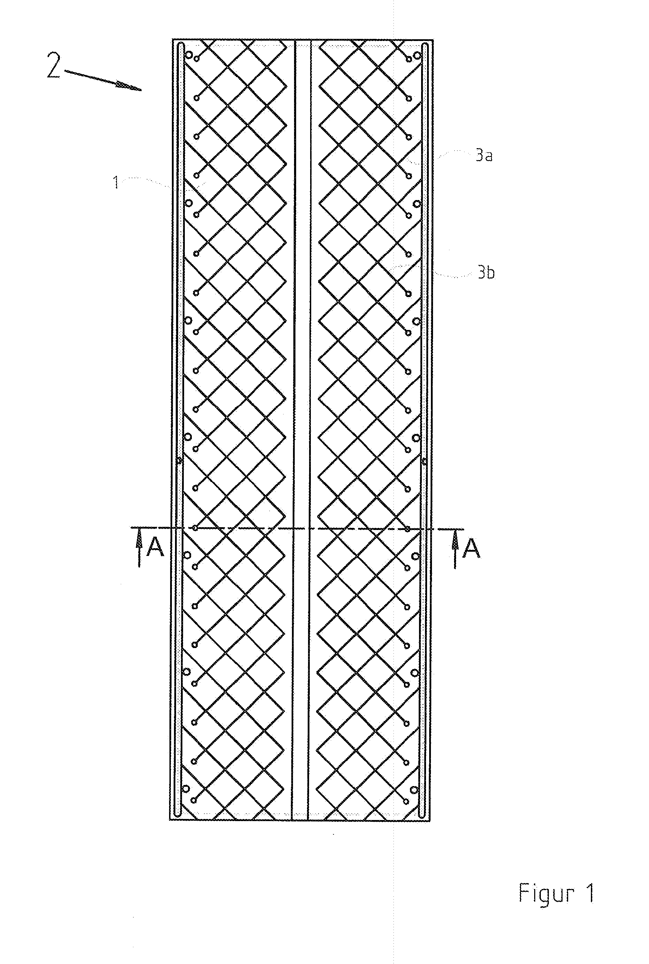

Figur 1 zeigt eine Grundplatte 1 eines berührungslosen Transportsystems 2 für Gegenstände aus empfindlichen Materialien, insbesondere Wafer für die Solarzellenfertigung.

Die Grundplatte 1 ist rechteckig ausgebildet und umfasst eine Druckluftversorgung, wobei die Drucklufterzeugung extern an anderer Stelle erfolgt. Die Druckluftversorgung umfasst dabei Auslassöffnungen in der Grundplatte 1, durch welche die Druckluft austritt und den in der Zeichnung nicht dargestellten Gegenstand von der Grundplatte weg anhebt.

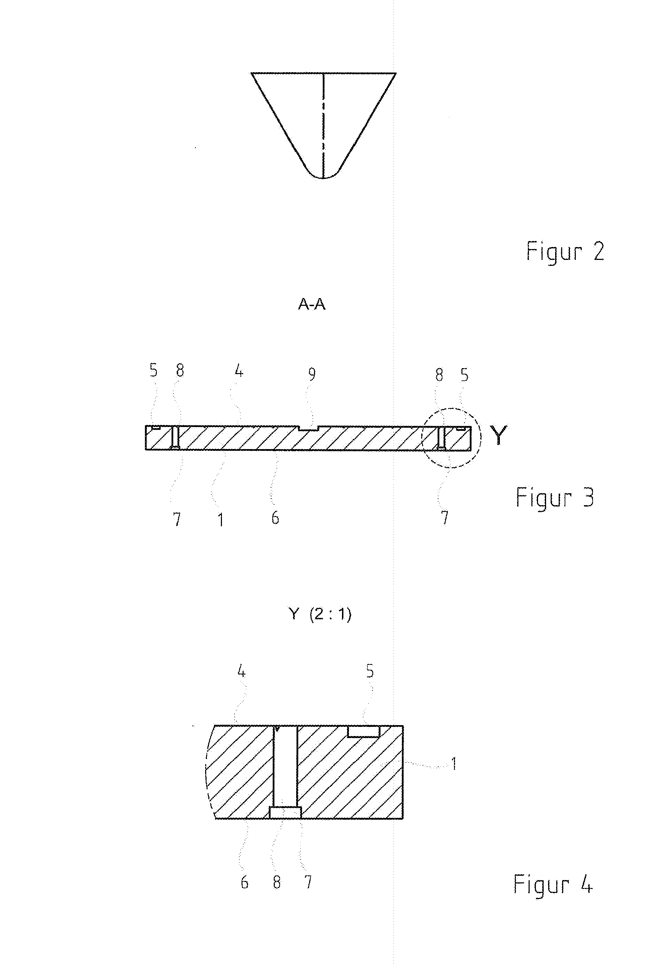

Dabei sind die Auslassöffnungen als längliche nutförmige Kanäle 3 ausgebildet sind, welche an der Oberfläche 4 der Grundplatte 1 verlaufen. Die Kanäle sind - wie aus Figur 2 ersichtlich - oberseitig offen ausgebildet und weisen einen sich oberseitig erweiternden, V-förmigem Querschnitt auf.

Gemäß Figur 1 ist ein erster Teil 3a der Kanäle 3 in einem Winkel von 45° zur Vorschubrichtung, welche im dargestellten Ausführungsbeispiel von rechts nach links weist, ausgerichtet angeordnet, wohingegen ein zweiter Teil 3b der Kanäle in einem Winkel von 135° zur Vorschubrichtung ausgerichtet ist. Dabei kreuzen sich die Kanäle kreuzen und grenzen endseitig aneinander an, so dass sie somit ineinander übergehen und als Teilbereiche eines rechtwinklig abknickenden Kanals ausgebildet sind.

Die Kanäle 3 des ersten Teils 3a erstrecken sich seitlich bis in den Randbereich der Grundplatte 1 und reichen nur soweit, dass sie den mittleren Bereich der Grundplatte freilassen.

Der erste Teil 3a der Kanäle 3 ist seitlich jeweils mit einer ersten Duckluftzufuhr versehen, die als ein nutförmig in der Oberfläche der Grundplatte eingebrachter und oberseitig mit einer in der Zeichnung nicht dargestellten Abdeckung verschlossener Verteil-Kanal 5, in welchen der erste Teil 3a der Kanäle 3 mündet, ausgebildet ist. Der Verteil-Kanal 5 ist wiederum über einen seitlichen Anschluss mir der Druckluft-Erzeugung, welche über entsprechende Regelungen gesteuert wird, verbunden. Dies ist auch aus Figur 3, die den Schnitt A-A der Figur 1 zeigt, sowie der Ausschnittvergrößerung des Details Y gemäß Figur 4 ersichtlich.

Ein zweiter Teil 3b der Kanäle 3 ist seitlich jeweils mit einer zweiten Duckluftzufuhr versehen, die als ein nutförmig in der Unterseite 6 der Grundplatte 1 eingebrachter und mit einer in der Zeichnung nicht dargestellten Abdeckung verschlossener weiterer Verteil-Kanal 7 ausgebildet, in welchen über aus Figur 4 ersichtliche Durchlässe 8 der zweite Teil 3b der Kanäle 3 mündet.

Wie in Figur 3 dargestellt, ist die Grundplatte 1 oberseitig mit einer mittigen Nut 9 versehen, die insbesondere zur Aufnahme einer Sensorik, beispielsweise zur Kontrolle von Prozessparametern ausgebildet sein kann.

Seitlich kann die Grundplatte 1 mit insbesondere leistenförmigen Anschlägen versehen sein, welche gleichzeitig auch die Abdeckung des Verteil-Kanals 5 bilden, versehen sein. Hierdurch ist eine seitliche Begrenzung des Transportweges gegeben, wobei die seitlich horizontal ausströmende Luft ein seitliches Luftpolster resultiert und damit einen Kontakt des zu transportierenden Gegenstandes mit den seitlichen leistenförmigen Anschlägen verhindert.

Durch gesteuerte und kontrollierte Veränderung der austretenden Druckluft ist eine gezielte Beeinflussung der Fördergeschwindigkeit möglich, wobei durch Beaufschlagung des ersten und/oder zweiten Teils der Kanäle eine Richtungsbeeinflussung bis hin zum auf der Stelle Schweben möglich ist. Durch Einstellen der Druckluftversorgung ist ein Absetzen möglich.

Insoweit können auch Komponenten einer Steuereinrichtung und entsprechende Sensorkomponenten vorgesehen sein, die insbesondere im mittleren Bereich der Grundplatte vorgesehen sein können.

Vorteilhafterweise kann zumindest eine Druckluftzufuhr auch umgekehrt beaufschlagbar sein, d. h. es kann eine Luftabsaugung erfolgen, wodurch eine Fixierung des Gegenstandes auf der Grundplatte 1 erfolgt.

Die Grundplatte 1 kann selbstverständlich auch als Teil eines Magazins oder einer Hebe- und/oder Wendeeinrichtung ausgebildet sein.

## Patentansprüche

1. Berührungsloses Transportsystem (2) für Gegenstände aus empfindlichen Materialien, insbesondere Wafer, mit einer insbesondere rechteckigen Grundplatte (1) und einer Druckluftversorgung, wobei die Grundplatte (1) Auslassöffnungen aufweist, durch welche die Druckluft austritt und den Gegenstand von der Grundplatte (1) weg anhebt, **dadurch gekennzeichnet, dass** die Auslassöffnungen als längliche nutförmige Kanäle (3) ausgebildet sind, welche an der Oberfläche (4) der Grundplatte (1) verlaufen und oberseitig offen ausgebildet sind.

2. Berührungsloses Transportsystem (2) nach dem vorhergehenden Anspruch, **dadurch gekennzeichnet, dass** die Kanäle (3) sich oberseitig erweiternd, insbesondere mit in etwa V-förmigem Querschnitt, ausgebildet sind.

3. Berührungsloses Transportsystem (2) nach dem vorhergehenden Anspruch, **dadurch gekennzeichnet, dass** die in etwa V-förmigem Kanäle (3) eine Tiefe von ca. 0,5 mm haben und der V-förmigem Querschnitt in etwa einen Winkel von. 50° bis 70°, insbesondere 60°, einschließt.

4. Berührungsloses Transportsystem (2) nach einem der vorhergehenden Ansprüche, **dadurch gekennzeichnet, dass** ein erster Teil (3a) der Kanäle (3) in einem Winkel von ca. 30° bis 60°, insbesondere 45°, zur Vorschubrichtung ausgerichtet angeordnet ist.

5. Berührungsloses Transportsystem (2) nach einem der vorhergehenden Ansprüche, **dadurch gekennzeichnet, dass** ein zweiter Teil (3b) der Kanäle (3) in einem Winkel von ca. 120° bis 150°, insbesondere 135°, zur Vorschubrichtung ausgerichtet angeordnet ist.

6. Berührungsloses Transportsystem (2) nach einem der vorhergehenden Ansprüche, **dadurch gekennzeichnet, dass** zumindest ein Teil der Kanäle (3) sich seitlich bis in den Randbereich der Grundplatte (1) erstreckt und insbesondere maximal bis zum mittleren Bereich der Grundplatte (1) reicht oder diesen freilässt.

7. Berührungsloses Transportsystem (2) nach einem der vorhergehenden Ansprüche, **dadurch gekennzeichnet, dass** ein erster Teil (3a) der Kanäle (3) seitlich jeweils mit einer ersten Duckluftzufuhr versehen ist.

8. Berührungsloses Transportsystem (2) nach dem vorhergehenden Anspruch, **dadurch gekennzeichnet, dass** die Druckluftzufuhr als ein nutförmig in der Oberfläche (4) der Grundplatte eingebrachter und oberseitig mit einer Abdeckung verschlossener Verteil-Kanal (5) ausgebildet ist, in welchen der erste Teil (3a) der Kanäle (3) mündet.

9. Berührungsloses Transportsystem (2) nach einem der vorhergehenden Ansprüche, **dadurch gekennzeichnet, dass** ein zweiter Teil (3b) der Kanäle (3) seitlich jeweils mit einer zweiten Duckluftzufuhr versehen ist.

10. Berührungsloses Transportsystem (2) nach dem vorhergehenden Anspruch, **dadurch gekennzeichnet, dass** die Druckluftzufuhr als ein nutförmig in der Unterseite (6) der Grundplatte (1) eingebrachter und mit einer Abdeckung verschlossener Verteil-Kanal (7) ausgebildet ist, in welchen über Durchlässe (8) der zweiten Teil (3b) der Kanäle (3) mündet.

11. Berührungsloses Transportsystem (2) nach einem der vorhergehenden Ansprüche, **dadurch gekennzeichnet, dass** die Grundplatte (1) oberseitig mit einer mittigen Nut (9) versehen ist, die insbesondere zur Aufnahme einer Sensorik ausgebildet ist.

12. Berührungsloses Transportsystem (2) nach einem der vorhergehenden Ansprüche, **dadurch gekennzeichnet, dass** die Grundplatte (1) aus Metall besteht und die Kanäle eingefräst sind.

13. Berührungsloses Transportsystem (2) nach einem der vorhergehenden Ansprüche, **dadurch gekennzeichnet, dass** die Kanäle (3) in Vorschubrichtung gesehen in einem Abstand von 5 mm bis 30 mm vorgesehen sind.

14. Berührungsloses Transportsystem (2) nach einem der vorhergehenden Ansprüche, **dadurch gekennzeichnet, dass** zumindest ein Teil der Kanäle (3) in der bevorzugten Vorschubrichtung eine sich verringernde Kanaltiefe und/oder ein sich verringerndes Kanalvolumen aufweisen.

15. Berührungsloses Transportsystem (2) nach einem der vorhergehenden Ansprüche, **dadurch gekennzeichnet, dass** zumindest ein Teil der Kanäle (3) sich von der einen Seite der Grundplatte (1) bis zur anderen Seite der Grundplatte (1) erstreckt.

16. Berührungsloses Transportsystem (2) nach einem der vorhergehenden Ansprüche, **dadurch gekennzeichnet, dass** der seitliche Querschnittsverlauf der Grundplatte (1) eben oder gekrümmt ausgebildet ist.
